**Europäisches Patentamt**

**European Patent Office**

**Office européen des brevets**

(19)

(11) Veröffentlichungsnummer: **0 244 577 B1**

(12) # EUROPÄISCHE PATENTSCHRIFT

(45) Veröffentlichungstag der Patentschrift:
02.01.91 Patentblatt 91/01

(51) Int. Cl.$^5$: **H01L 43/06, H01L 27/22**

(21) Anmeldenummer: **87102488.1**

(22) Anmeldetag: **21.02.87**

(54) Integrierbares Hallelement.

(30) Priorität: **29.04.86 CH 1759/86**

(43) Veröffentlichungstag der Anmeldung:
**11.11.87 Patentblatt 87/46**

(45) Bekanntmachung des Hinweises auf die
Patenterteilung:
**02.01.91 Patentblatt 91/01**

(84) Benannte Vertragsstaaten:
**AT BE CH DE ES FR GB IT LI NL SE**

(56) Entgegenhaltungen:
**EP-A- 0 035 103**
**EP-A- 0 148 330**

(73) Patentinhaber: **Landis & Gyr Betriebs AG**
**CH-6301 Zug (CH)**

(72) Erfinder: **Popovic, Radivoje**
**Fridbach 1**
**CH-6300 Zug (CH)**
Erfinder: **Krause, Axel**
**Meierskappelerstrasse 6**
**CH-6343 Rotkreuz (CH)**

EP 0 244 577 B1

Jouve, 18, rue Saint-Denis, 75001 PARIS

## Beschreibung

Die Erfindung bezieht sich auf ein integrierbares Hallelement gemäss dem Oberbegriff des Anspruchs 1.

Derartige Hallelemente werden mit Vorteil in Elektrizitätszählern oder Leistungsmessern verwendet zur Messung eines von einem elektrischen Strom erzeugten Magnetfeldes.

Ein integriertes Hallelement der eingangs genannten Art ist z.B. aus der EP 0 148 330 A2 bekannt. Dieses Hallelement, nachfolgend kurz vertikales Hallelement genannt, misst ein Magnetfeld, welches parallel zu seiner Oberfläche wirksam ist.

Aus der US-PS 4,253,107 ist ein weiteres integriertes Hallelement der eingangs genannten Art bekannt, das ein Magnetfeld misst, welches senkrecht zu seiner Oberfläche wirksam ist, und daher nachfolgend kurz horizontales Hallelement genannt wird.

Die EP 0 035 103 Al beschreibt eine Anordnung zur Kompensation von Piezoeffekten, die aus zwei vollständigen Hallelementen besteht, die gegeneinander um einen Winkel von 90 Grad um eine senkrecht zur Oberfläche verlaufende Achse verdreht angeordnet sind. Die zweipoligen Stromeingänge und Sensorausgänge der beiden Hallelemente sind parallel geschaltet.

Der Erfindung liegt die Aufgabe zugrunde, trotz dem Vorhandensein sehr dünner Halbleiterschichten, ein integrierbares, beliebig grosses Hallelement mit geringer Nichtlinearität und kleinem 1/f-Rauschen zu realisieren. Dabei ist die effektive Länge eines vertikalen Hallelementes bedeutend grösser als die Dicke der Halbleiterschicht.

Die genannte Aufgabe wird erfindungsgemäss durch die im Kennzeichen des Anspruchs 1 angegebenen Merkmale gelöst.

Ausführungsbeispiele der Erfindung sind in der Zeichnung dargestellt und werdem im folgenden näher beschrieben.

Es zeigen :

Fig. 1 eine schematische Darstellung eines mehrfach aufgeteilten Hallelementes,

Fig. 2a eine schematische Darstellung eines mehrfach aufgeteilten vertikalen Hallelementes,

Fig. 2b einen Querschnitt eines mehrfach aufgeteilten integrierten vertikalen Hallelementes,

Fig. 3 eine schematische Darstellung eines zweifach aufgeteilten vertikalen Hallelementes in Summenschaltung,

Fig. 4 eine schematische Darstellung eines zweifach aufgeteilten vertikalen Hallelementes in Differenzschaltung,

Fig. 5 eine weitere Variante eines zweifach aufgeteilten vertikalen Hallelementes in Summenschaltung,

Fig. 6 ein zweifach aufgeteiltes integriertes vertikales Hallelement,

Fig. 7 einen Querschnitt eines zweifach aufgeteilten integrierten horizontalen Hallelementes,

Fig. 8 eine Draufsicht des zweifach aufgeteilten integrierten horizontalen Hallelementes,

Fig. 9a ein elektrisches Ersatzbild eines bekannten Hallelementes und

Fig. 9b ein elektrisches Ersatzschaltbild des in den Figuren 7 und 8 dargestellten horizontalen Hallelementes.

Gleiche Bezugszahlen bezeichnen in allen Figuren der Zeichnung gleiche Teile.

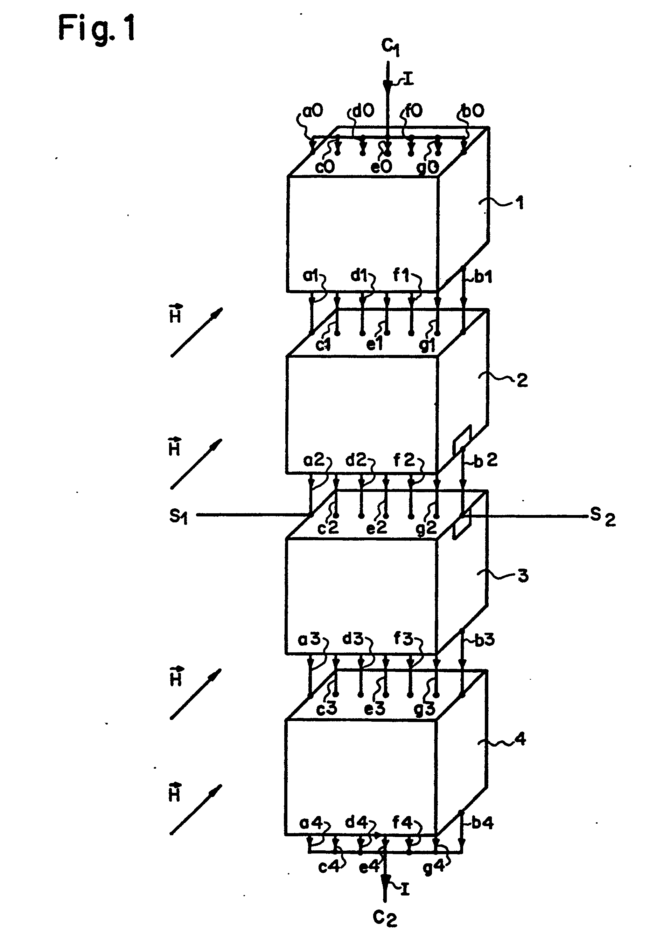

Das in der Fig. 1 dargestellte, mehrfach aufgeteilte Hallelement besteht aus einem bekannten Hallelement in Gestalt eines rechtwinkligen Parallelepipeds aus Halbleitermaterial, welches zwei Stromanschlüsse $C_1$ und $C_2$ sowie zwei Sensoranschlüsse $S_1$ and $S_2$ besitzt, die jeweils an zwei gegenüberliegenden Seiten des Parallelepipeds angeordnet sind, dessen verbleibende zwei parallele Seiten senkrecht zu einem zu messenden Magnetfeld $\vec{H}$ angeordnet sind. Dieses bekannte Hallelement ist mindestens durch eine Schnittfläche in mehrere Anordnungen aufgeteilt, wobei die Zentren der Anschlusskontakte der Sensoranschlüsse $S_1$ und $S_2$ beide zusammen in einer gemeinsamen Schnittfläche liegen. Die Schnittflächen brauchen weder planparallel, noch eben und senkrecht zur Stromdichte im Hallelement zu sein. In der Zeichnung wurde aus Gründen der zeichnerischen Einfachheit angenommen, dass alle Schnittflächen plan-parallel und senkrecht zur Stromdichte angeordnet sind, d.h. senkrecht zur Verbindungslinie der beiden Zentren der Anschlusskontakte der beiden Stromanschlüsse $C_1$ und $C_2$ liegen.

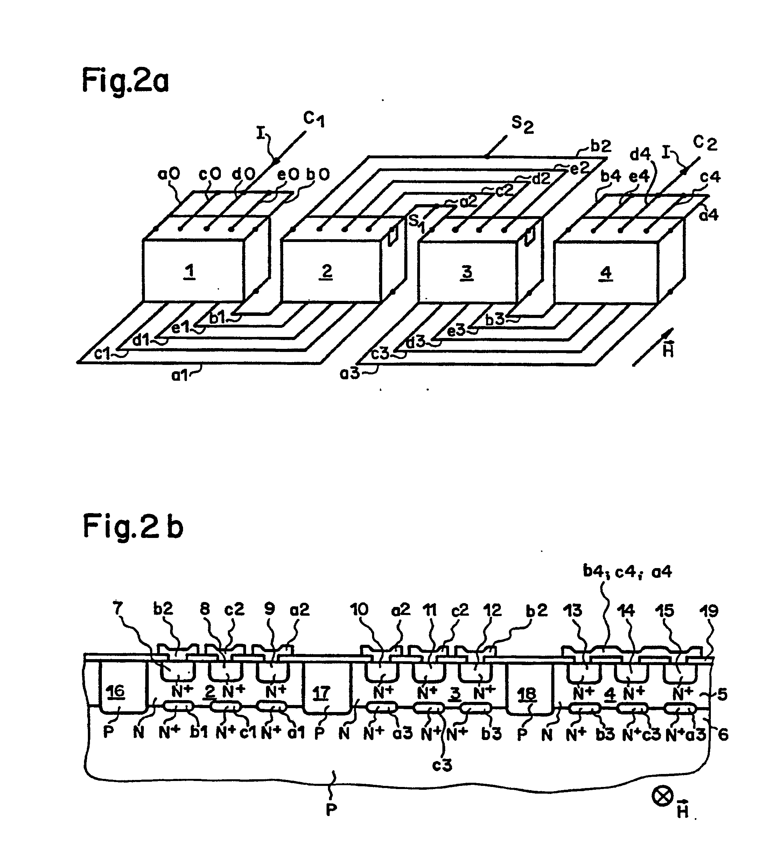

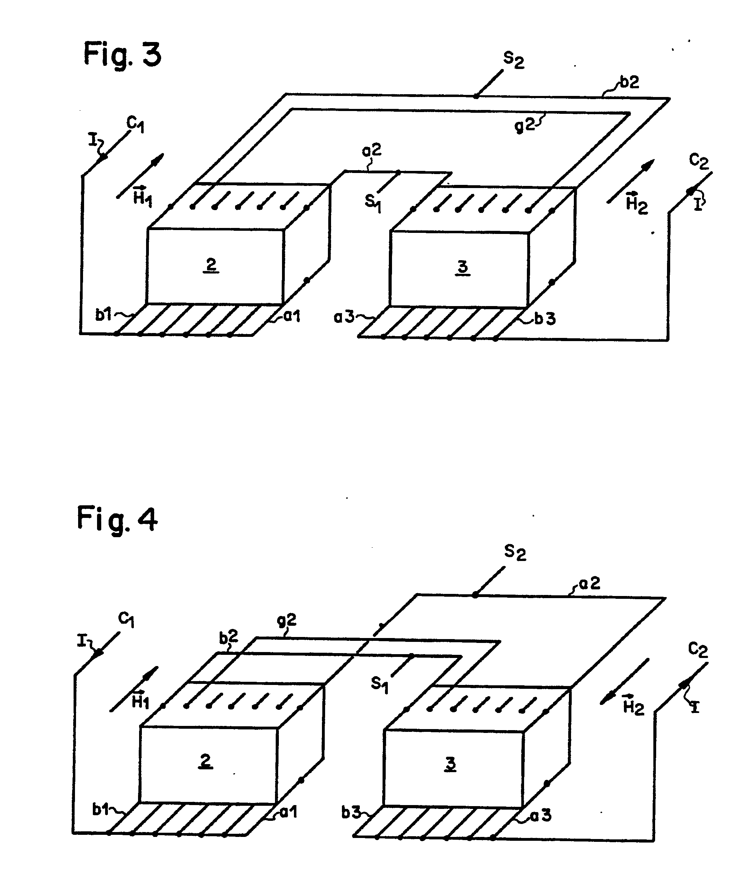

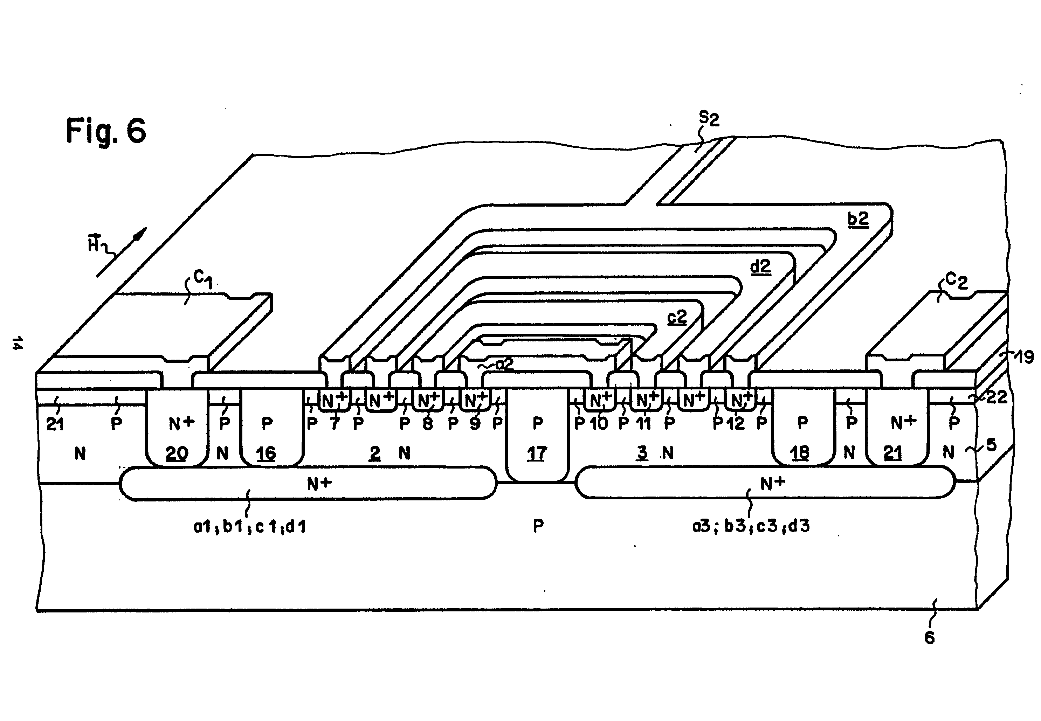

In den Figuren 1, 2a und 2b wurde angenommen, dass drei Schnittflächen und somit vier Anordnungen 1, 2, 3 und 4 vorhanden sind. In den Figuren 3 bis 8 gilt die Annahme, dass nur eine Schnittfläche und somit zwei Anordnungen 2 und 3 vorhanden sind. Je zwei Punkte an beiden Seiten einer jeden Schnittfläche sind mit einem in Gedanken als elastisch angenommenen und elektrisch leitenden Draht verbunden. Es gibt theoretisch unendlich viele solcher Punkte und solcher Drähte. Die Punkte liegen z.B. alle annähernd auf einer geraden Linie. In der Fig. 1 und in den Figuren 3 bis 5 wurde das Vorhandensein von je sieben Verbindungen a bis g pro Schnittfläche, in der Figur 2a von je fünf Verbindungen a bis e pro Schnittfläche, in der Figur 2b von je drei Verbindungen a bis c pro Schnittfläche und in den Figuren 6 bis 8 von je vier Verbindungen a bis d pro Schnittfläche angenommen. Es müssen auf jeden Fall jeweils mindestens zwei solcher Verbindungen a und b pro Schnittfläche vorhanden sein. Mit Vorteil werden als die beiden Aequipotentialpunkte, die mindestens vorhanden sein müssen, in der mittleren Schnittfläche diejenigen zwei Punkte gewählt, die das gleiche elektrische Potential besitzen wie die Sensoranschlüsse $S_1$ und $S_2$. D. h. : Jeder der beiden äusseren Aequipotentialpunkte der mittleren Schnittfläche ist jeweils mit einem der beiden Sensorschlüsse $S_1$ und $S_2$ derart zu verbinden, dass er dessen elektrisches Potential annimmt.

Somit sind jeweils mindestens zwei von mehreren Punkten einer jeden oberen und einer jeden unteren Fläche einer jeden Anordnung 1 bis 4 mit je einem Aequipotentialpunkt der entgegengesetzt benannten Fläche einer benachbarten Anordnung verbunden.

Bei räumlicher Trennung der vier Anordnungen 1 bis 4 durch Parallelverschiebung werden die als elastisch angenommenen Verbindungen zwar länger, das in der Fig. 1 dargestellte Hallelement arbeitet jedoch dank der Verbindungen und trotz der räumlichen Trennung der Anordnung 1 bis 4 genau so, als ob keine Schnittflächen vorhanden wären, da die Verbindungen äquipotentielle Punkte miteinander verbinden. In der Fig. 1 befinden sich zwischen den Anordnungen 1 und 2 die sieben Verbindungen a1 bis g1, zwischen den Anordnungen 2 und 3 die sieben Verbindungen a2 bis g2 und zwischen den Anordnungen 3 und 4 die sieben Verbindungen a3 bis g3.

Die als Aequipotentialpunkte gewählten Punkte der äusseren Flächen der beiden äusseren Anordnungen 1 und 4 sind jeweils untereinander und mit dem dieser Fläche jeweils zugeordneten Stromanschluss $C_1$ bzw. $C_2$ elektrisch verbunden, d.h. die sieben Verbindungen a0 bis g0 an der, in der Darstellung der Zeichnung, oberen Fläche der oberen Anordnung 1 sind alle mit dem ersten Stromanschluss $C_1$ und diejenigen a4 bis g4 an der unteren Fläche der unteren Anordnung 4 alle mit dem zweiten Stromanschluss $C_2$ verbunden.

Ein Speisestrom I fliesst im Betrieb über den ersten Stromanschluss $C_1$ und die parallelen Verbindungen a0 bis g0 in die Anordnung 1 und damit in das Hallelement hinein. Der Speisestrom I fliesst in der angegebenen Reihenfolge weiter durch die Anordnung 1, über die parallelen Verbindungen a1 bis g1, durch die Anordnung 2, über die parallelen Verbindungen a2 bis g2, durch die Anordnung 3, über die parallelen Verbindungen a3 bis g3, durch die Anordnung 4 und über die parallelen Verbindungen a4 bis g4 zu dem zweiten Stromanschluss $C_2$ und damit aus dem Hallelement heraus. Die durch diesen Speisestrom I und dem zu messenden Magnetfeld $\vec{H}$ im Hallelement erzeugte Hallspannung erscheint zwischen den beiden Sensoranschlüssen $S_1$ und $S_2$. Es verbleibt darauf hinzuweisen, dass jede Anordnung 1 bis 4 für sich allein betrachtet kein vollständiges Hallelement darstellt.

Die Anordnungen 1 bis 4 können beliebig voneinander entfernt und sogar gegeneinander verdreht werden, unter der Bedingung, dass im Betrieb die vektoriellen Richtungen des Magnetfeldes $\vec{H}$, der

Stromdichte im Hallelement und des elektrischen Hallfeldes im Hallelement ihre relative Lage beibehalten (siehe Fig. 2a, Fig. 3 und Fig. 5).

In der Fig. 2a sind die Anordnungen 1 bis 4 annähernd in einer geraden Reihe nebeneinander angeordnet, wobei die Anordnungen 1 bis 4 abwechselnd nicht verdreht (Anordnungen 1 und 3) oder kopfstehend verdreht (Anordnungen 2 und 4) parallelverschoben derart angeordnet sind, dass mindestens die oberen Flächen der Anordnungen 1 bis 4 schliesslich alle in einen einzigen gemeinsamen Ebene liegen. Alle Verbindungen sind parallel untereinander. Die relative Lage der drei erwähnten vektoriellen Richtungen ist unverändert geblieben in Bezug auf ihre ursprüngliche Lage. Die Verbindungen a0 bis e0, a2 bis e2 und a4 bis e4 sind alle oberhalb und die Verbindungen a1 bis e1 und a3 bis e3 alle unterhalb der Anordnungen 1 bis 4 angeordnet.

Das in der Fig. 2b dargestellte integrierte vertikale Hallelement stellt eine praktische Realisation der in der Fig. 2a dargestellten schematischen Anordnung dar. Die gemeinsame Ebene, in der die oberen Flächen der Anordnungen 1 bis 4 liegen, ist die Oberflächenebene einer Halbleiterschicht 5, in der gemeinsam alle Anordnungen 1 bis 4 angeordnet sind. Die Halbleiterschicht 5 ist z. B. eine dünne Epitaxie-Schicht, die auf einem Substrat 6 aufgewachsen ist. In der Fig. 2b sind einfachshalber nur die drei Anordnungen 2 bis 4 dargestellt. Die in der Darstellung der Zeichnung unterhalb der Anordnungen 1 bis 4 gelegenen Verbindungen a1 bis c1 und a3 bis c3, d. h. ein Teil der Verbindungen zwischen Aequipotential-Punkten, bestehen aus je einer vergrabenen Schicht ("buried layer"), die jeweils in der Grenzschicht zwischen Substrat 6 und Halbleiterschicht 5 angeordnet sind. Die Anordnungen 1 und 2 besitzen je als vergrabene Schichten die Verbindungen a1 bis c1, die in der Fig. 2b nur für die Anordnung 2 dargestellt sind, und die Anordnungen 3 und 4 je als vergrabene Schichten die Verbindungen a3 bis c3. In dem in der Fig. 2b dargestellten Querschnitt liegt jeder vergrabenen Schicht an der Oberfläche in der Halbleiterschicht 5 je eine Kontaktdiffusion gegenüber. Diese sind in der Fig. 2b für die Anordnung 2 mit 7 bis 9, für die Anordnung 3 mit 10 bis 12 und für die Anordnung 4 mit 13 bis 15 bezeichnet. Der andere Teil der Verbindungen, d.h. die in der Darstellung der Zeichnung oberhalb der Anordnungen 1 bis 4 gelegenen Verbindungen a0 bis c0 (in der Fig. 2b nicht dargestellt, da nur bei der nicht dargestellten Anordnung 1 vorhanden), a2 bis c2 und a4 bis c4, hat je einen elektrischen Kontakt mit je einer der Kontaktdiffusionen. Diese Verbindungen bilden zusammen die sogenannte Metallisierung der integrierten Schaltung und sind auf der Oberfläche der Halbleiterschicht 5 aufgetragen. Die Metallisierung besteht aus Metall, z.B. Aluminium, oder aus elektrisch leitendem Polysilizium. Zwecks elektrischer Isolation befindet sich zwischen der Metallisierung und der Halbleiterschicht 5 eine Isolationsschicht 19, die z.B. aus $SiO_2$ besteht. Die Metallisierung liegt direkt auf dieser Isolationsschicht 19, die ihrerseits direkt auf der Halbleiterschicht 5 aufliegt. Die Verbindungen a4 bis c4 der Anordnung 4 sind untereinander verbunden zwecks Anschluss an ihrem gemeinsamen Stromanschluss $C_2$. Jede Anordnung 1 bis 4 ist zwecks Inselbildung und Isolation von den benachbarten Anordnungen mit einem z.B. rechteckförmigen Isolationsring seitlich umgeben, wobei zwei benachbarte Isolationsringe je einen gemeinsamen Steg 16 ;17 oder 18 besitzen. Der Isolationsring 16 ;17 umgibt dabei z. B. die Anordnung 2 und der Isolationsring 17 ;18 z.B. die Anordnung 3. Die Isolationsringe reichen von der Oberfläche der Halbleiterschicht 5 bis tief hinunter, z.B. bis zum räumlichen Kontakt mit dem Substrat 6.

Das Substrat 6, die Isolationsringe und ihre Stege 16, 17 und 18 bestehen alle aus einem Halbleitermaterial eines gleichen Materialleitfähigkeitstyps, z.B. aus P-Material. Es könnte natürlich auch N-Material sein. Die Halbleiterschicht 5, die vergrabenen Schichten und die Kontaktdiffusionen 7 bis 15 bestehen alle aus einem Halbleitermaterial vom andern Materialleitfähigkeitstyp, also im Beispiel aus N-Material. Die vergrabenen Schichten und die Kontaktdiffusionen 7 bis 15 sind alle stark mit Fremdatomen dotiert, d. h. sie bestehen aus $N^+$-Material.

Die in der Fig. 3 dargestellte schematische Anordnung ähnelt der in der Fig. 2a dargestellten Anordnung, mit dem Vorteil, dass nur mehr zwei Anordnungen 2 und 3 vorhanden sind, was dazu führt, dass die Verbindungen zu den beiden Stromanschlüssen $C_1$ und $C_2$ sich an den unteren Flächen der Anordnungen 2 und 3 befinden und nicht, wie in der Fig. 2a, an den oberen Flächen der Anordnungen 1 und 4.

Die in der Fig. 4 dargestellte schematische Anordnung entspricht der in der Fig. 3 dargestellten Anordnung, mit dem Unterschied, dass die Verbindungen an der Oberfläche der Anordnungen 2 und 3 nicht mehr parallel, sondern über Kreuz verlaufen. Dadurch stimmt zwar die relative Lage der drei erwähnten vektoriellen Richtungen mit der ursprünglichen Lage überein, jedoch nicht mehr der Richtungssinn einer der vextoriellen Richtungen das Magnetfeld hat nämlich seine relative Lage am Ort der Anordnung 3 praktisch um 180° gedreht. D. h., dass das in der Fig. 4 dargestellte Hallelement nicht mehr wie das in der Fig. 3 dargestellte Hallelement die Summe $\overrightarrow{H1}+\overrightarrow{H2}$, sondern die Differenz $\overrightarrow{H1}-\overrightarrow{H2}$ zweier Magnetfelder $\overrightarrow{H1}$ und $\overrightarrow{H2}$ misst, wobei $\overrightarrow{H1}$ das Magnetfeld am Ort der Anordnung 2 und $\overrightarrow{H2}$ das Magnetfeld am Ort der Anordnung 3 ist. Anders ausgedrückt : Mit dem in der Fig. 4 dargestellten Hallelement kann ein Magnetfeld-Gradient zwischen zwei räumlich entfernten Punkten gemessen werden.

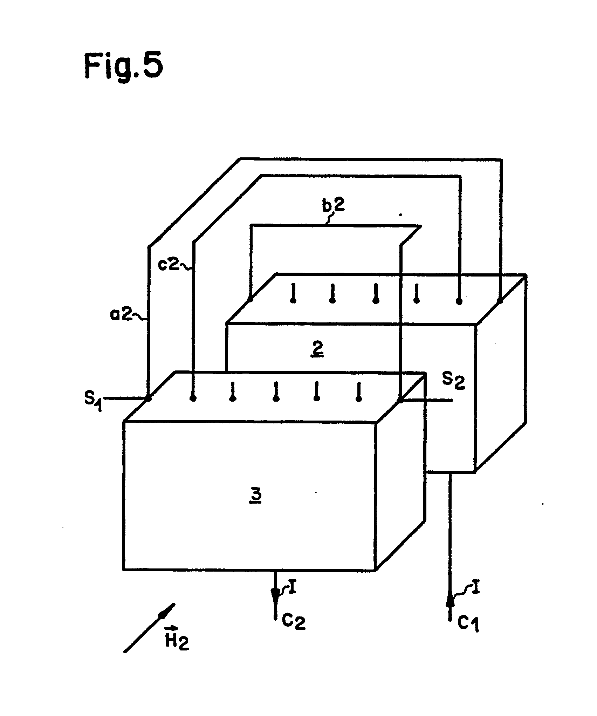

Das in der Fig. 5 schematisch dargestellte Hallelement entspricht annähernd demjenigen, das in der Fig. 3 dargestellt ist, mit dem Unterschied, dass beide Anordnungen 2 und 3 nicht annähernd in einer Reihe nebeneinander, sondern annähernd in einer Reihe hintereinander angeordnet sind. Die in der Darstellung der Zeichnung oberen Verbindungen verlaufen allerdings über Kreuz, diesmal um die relative Lage der drei vektoriellen Richtungen unverändert zu lassen.

In der Fig. 6 ist die praktische Realisation des in der Fig. 3 schematisch dargestellten Hallelementes als integrierte Schaltung dargestellt, wobei wiederum ein vertikales Hallelement entsteht. Das dargestellte Hallelement entspricht annähernd dem in der Fig. 2b dargestellten integrierten vertikalen Hallelement mit dem Unterschied, dass diesmal nur mehr zwei Anordnungen 2 und 3 vorhanden sind.

Die mit einem Stromanschluss $C_1$ bzw. $C_2$ zu verbindende Punkte an den unteren Flächen der beiden jetzt äusseren Anordnungen 2 und 3 bilden diesmal je eine einzige gemeinsame vergrabene Schicht a1 ;b1 ;c1 ;d1 bzw. a3 ;b3 ;c3 ;d3 pro Anordnung 2 bzw. 3, die durch je eine tiefe Diffusion 20 bzw. 21, die voll durch die Halbleiterschicht 5 hindurch geht, mit der Oberfläche des Hallelementes, d. h. der integrierten Schaltung, verbunden ist. Die tiefe Diffusion 20 bzw. 21 ist jeweils dort mit einem Stromanschluss $C_1$ bzw. $C_2$ des Hallelementes verbunden. Die tiefen Diffusionen 20 und 21 bestehen aus Material, das vom gleichen Materialleitfähigkeitstyp ist wie die vergrabenen Schichten und das wie diese stark mit Fremdatomen dotiert ist, d.h. sie bestehen aus $N^+$-Material.

Die gemäss den Figuren 2b und 6 realisierten integrierten vertikalen Hallelemente haben den Vorteil, dass sie im Gegensatz zum bekannten vertikalen Hallelement, dessen beide Stromanschlüsse $C_1$ und $C_2$ sehr unterschiedlich aufgebaut sind und sehr unterschiedliche Abmessungen aufweisen, genau symmetrische Eigenschaften in beiden Stromrichtungen besitzen.

Zur Gewährleistung der Langzeitstabilität ist die Oberfläche der Halbleiterschicht 5 in der Fig. 6 mit einer dünnen Oberflächenschicht 22 bedeckt, die aus dem gleichen Material P besteht wie das Substrat 6. Alle Kontaktdiffusionen 7 bis 12, alle Stege 16 bis 18 und die beiden tiefen Diffusionen 20 und 21 durchqueren voll diese dünne Oberflächenschicht 22. Das in der Fig. 2b dargestellte vertikale Hallelement besitzt mit Vorteil ebenso eine solche dünne Oberflächenschicht 22, die allerdings in der Fig. 2b nicht dargestellt ist.

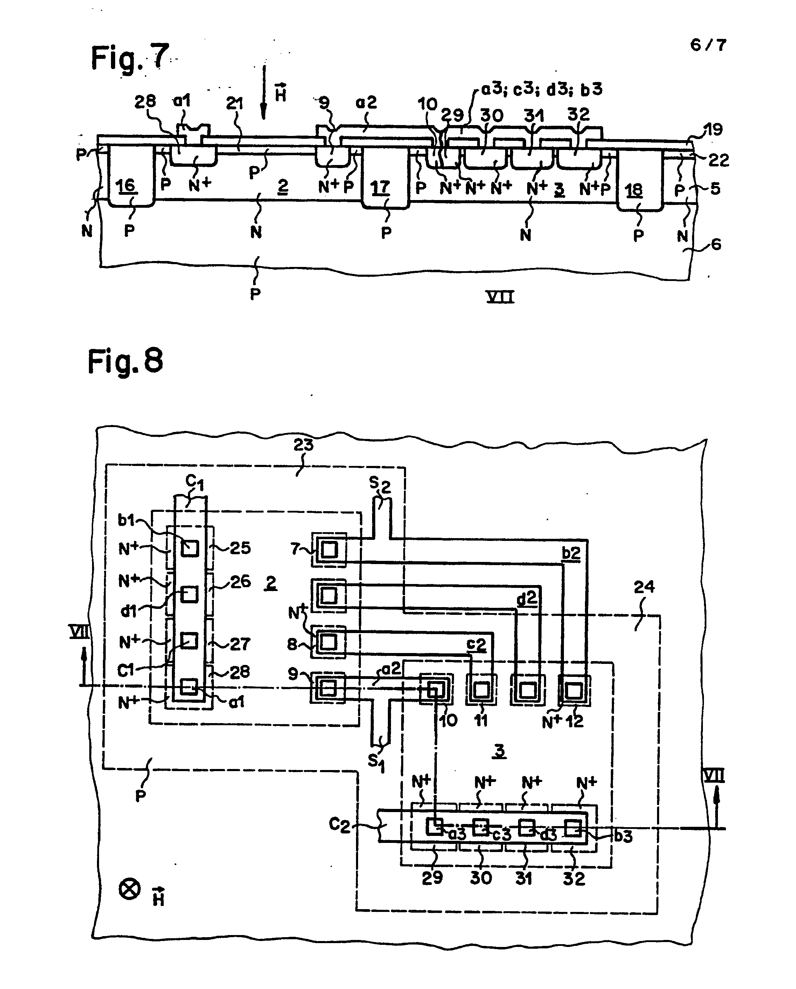

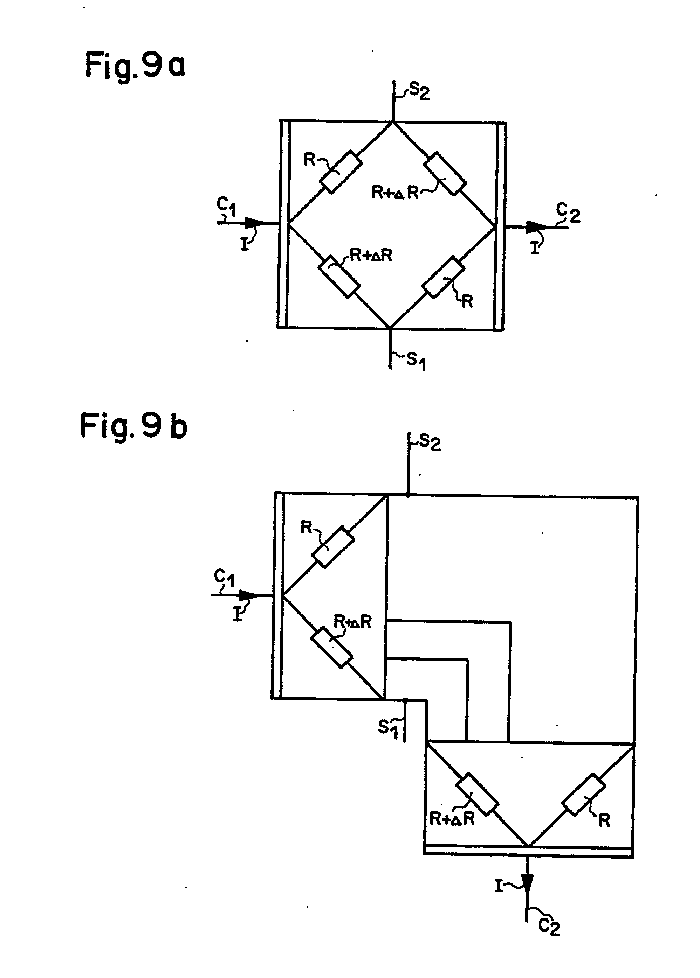

Die beiden Figuren 7 und 8 stellen den Querschnitt VII bzw. die Draufsicht eines gleichen horizontalen Hallelementes dar. Es besteht ebenfalls aus zwei Anordnungen 2 und 3, die jedoch nicht in einer Reihe nebeneinander, sondern in der Draufsicht um einen Winkel von annähernd 90° gegeneinander verdreht, d.h. um einen Winkel von zunähernd 90° um eine senkrecht zur Oberfläche verlaufende Achse verdreht, in der Halbleiterschicht 5 angeordnet sind. Die räumliche Anordnung und das Material des Substrats 6, der Halbleiterschicht 5, der Oberflächenschicht 22, der Isolationsschicht 19, der Metallisierung und der Stege 16, 17 und 18 der Isolierringe, die in der Fig. 8 mit 23 und 24 bezeichnet sind, sind gleich wie in der Fig. 6. Alle Verbindungen a1 bis d1, a2 bis d2 und a3 bis d3 befinden sich als Metallisierung an der Oberfläche der integrierten Schaltung. Es existieren somit diesmal keine vergrabenen Schichten. Diese sind durch Kontaktdiffusionen 25 bis 32 ersetzt worden, wobei die Kontaktdiffusionen 25 bis 28 einerseits und die Kontaktdiffusionen 29 bis 32 anderseits mit Vorteil annähernd in einer geraden Reihe angeordnet sind. Die Kontaktdiffusionen 25 bis 32 bestehen alle aus dem gleichen $N^+$-Material wie die Kontaktdiffusionen 7 bis 12. Die Verbindungslinien der Zentren der beiden Kontaktdiffusionsreihen 25 ; 26 ; 27 ; 28 und 29 ; 30 ; 31 ; 32 bilden annähernd einen Winkel von 90° miteinander. Jede Anordnung 2 und 3 besitzt zwei Kontaktdiffusionsreihen 25 ;26 ;27 ;28 und 7 ;8 ;9 bzw. 10 ;11 ;12 und 29 ;30 ;31 ;32, wobei jeweils eine Kontaktdiffusion der einen Reihe einer Kontaktdiffusion der andern Reihe an der Oberfläche in der Halbleiterschicht 5 gegenüber liegt. In jeder der beiden Kontaktdiffusionsreihen 7 ;8 ;9 und 10 ;11 ;12 ist in der Fig. 8 eine nicht nummerierte Kontaktdiffusion gezeichnet, die der Kontaktdiffusion 26 bzw. 31 gegenüber liegt. Die Kontaktdiffusionen 7 bis 9 einerseits und 10 bis 12 anderseits sind ebenfalls mit Vorteil annähernd in je einer geraden Reihe angeordnet, die vorzugsweise jeweils parallel ist zu der Kontaktdiffusionsreihe 25 ;26 ;27 ;28 bzw. 29 ;30 ;31 ;32. Die Verbindungen a2 bis d2 verbinden die Kontaktdiffusionen 7 bis 9 elektrisch mit den Kontaktdiffusionen 10 bis 12, wobei die Verbindungen a2 und d2 je einen Sensoranschluss $S_1$ bzw. $S_2$ besitzen. Der erste Stromanschluss $C_1$ des Hallelementes ist über die Verbindungen a1 bis d1 mit den Kontaktdiffusionen 25 bis 28 verbunden, die alle vier zur Anordnung 2 gehören. Der zweite Stromanschluss $C_2$ des Hallelementes ist über die Verbindungen a3 bis d3 mit den Kontaktdiffusionen 29 bis 32 verbunden, die alle vier zur Anordnung 3 gehören.

Das in den Figuren 7 bis 8 dargestellte horizontale Hallelement hat den Vorteil, dass seine Nullspannung ("Offset"-Spannung) weitgehend kompensiert wird, was nachfolgend anhand der Figuren 9a und 9b näher erläutert wird.

Die Fig. 9a stellt eine aus vier Widerständen bestehende Brückenschaltung dar, die das Ersatzschaltbild eines üblichen Hallelementes darstellt. Die Brückenschaltung enthält zwei unterschiedliche Widerstandswerte R und R+$\Delta$R, wobei jeweils zwei räumlich parallel angeordnete Widerstände, d.h., zwei in der Brückenschaltung diametral gegenüberliegende Widerstände, gleich sind. Die Widerstandsdifferenz $\Delta$R entsteht durch piezoresistive Effekte, geometrische Toleranzen usw. Bei einem Magnetfeld $\vec{H}$=0, entsteht am Sensorausgang $S_1$ ;$S_2$ des Hallelementes eine Nullspannung $V_{off}$= ($\Delta$R/R) $V_{C1, C2}$, wobei $V_{C1, C2}$ eine am Speisestromeingang $C_1$ ;$C_2$ des Hallelementes anstehende Speisespannung darstellt.

In der Fig. 9b ist das Ersatzschaltbild des in den Figuren 7 bis 8 dargestellten horizontalen Hallelementes wiedergegeben, das sich von dem in der Fig. 9a dargestellten Ersatzschaltbild dadurch unterscheidet, dass eine Hälfte der Brückenschaltung um 90° gegenüber der anderen Hälfte verdreht angeordnet ist. Da zwei räumlich parallel angeordnete Widerstände wieder gleich R bzw. R+$\Delta$R sind, liegen diesmal, in Flussrichtung des Speisestromes I betrachtet, zwei gleiche Widerstände elektrisch in Reihe, was dazu führt, dass $V_{off}$ = 0 wird.

Der Nullabgleich der Nullspannung $V_{off}$ kann im vertikalen Hallelement (siehe Fig. 3), dadurch realisiert werden, dass die Kurzschlussverbindungen a2 und b2 je durch zwei in Reihe geschaltete nicht dargestellte Widerstände ersetzt werden, deren gemeinsamer Pol jeweils mit einem der Sensoranschlüsse $S_1$ bzw. $S_2$ verbunden ist. Diese Widerstände sind als einstellbare Abgleichswiderstände zu realisieren. Sie bestehen z.B. vorzugsweise aus je einem Sperrschicht-Feldeffekttransistor (JFET) oder einem MOS-Feldeffekttransistor, dessen Source-Drain-Kanalwiderstand jeweils den Widerstand darstellt, dessen Widerstandswert mittels der Gate-Spannung des Feldeffekttransistors einstellbar ist.

Alle beschriebenen integrierten Hallelemente können in Standard-Bipolar-Integrierte Schaltungs-Technologie hergestellt werden. Dank der Verwendung mehrfach aufgeteilter Hallelemente können, trotz dem Vorhandensein einer dünnen Epitaxie-Schicht als Halbleiterschicht 5, beliebig grosse Hallelemente realisiert werden. Dies hat den Vorteil, dass die Nichtlinearitäten des Hallelementes gering sind und sein 1/f-Rauschen klein ist.

## Ansprüche

1. Integrierbares Hallelement mit einem ersten Stromanschluss ($C_1$), einem zweiten Stromanschluss ($C_2$) und zwei Sensoranschlüssen ($S_1$, $S_2$), welches im Betrieb mit einem elektrischen Hallfeld und einer Stromdichte versehen ist, dadurch gekennzeichnet, dass ein Hallelement, dessen beide Stromanschlüsse ($C_1$, C2) und dessen beide Sensoranschlüsse ($S_1$, $S_2$) jeweils an zwei seiner gegenüberliegenden Seiten angeordnet sind durch mindestens eine Schnittfläche quer zur vektoriellen Richtung der Stromdichte in mehrere Anordnungen (1, 2, 3, 4 bzw. 2, 3) aufgeteilt ist, dass in einer Schnittfläche die Zentren von Anschlusskontakten der Sensoranschlüsse (S₁, S₂) liegen, dass jeweils mindestens zwei Verbindungen pro Schnittfläche vorhanden sind, wodurch jeweils zwei beidseitig der Schnittfläche gelegene Aequipotentialpunkte zweier benachbarter Anordnungen elektrisch leitend verbunden sind, dass bei einer Schnittfläche die Aequipotentialpunkte Punkte sind, die das gleiche elektrische Potential besitzen wie die beiden Sensoranschlüsse (S₁, S₂), mit denen sie dann verbunden sind, und dass die Anordnungen (1, 2, 3, 4 bzw. 2, 3) derartig verschoben angeordnet sind, dass eine Fläche quer zur vektoriellen Richtung der Stromdichte aller Anordnungen (1, 2, 3, 4 bzw. 2, 3) jeweils in einer einzigen gemeinsamen Ebene liegt und im Betrieb die relative Lage der vektoriellen Richtungen der Stromdichte, des elektrischen Hallfeldes und eines zu messenden Magnetfeldes ($\vec{H}$) jeweils beibehalten bleibt, und dass die Anordnungen (1, 2, 3, 4 bzw. 2, 3) in einer Halbleiterschicht (5) angeordnet sind und die gemeinsame Ebene die Oberflächenebene der Halbleiterschicht (5) ist.

2. Integrierbares Hallelement nach Anspruch 1, dadurch gekennseichnet, dass die Halbleiterschicht (5) eine auf einem Substrat (6) aufgewachsene Epitaxie-Schicht ist, dass die Verbidungen zwischen Aequipotentialpunkten und verbidungen zu den Stromanschlüssen (C₁, C₂) teilweise aus vergrabenen Schichten bestehen, die in der Grenzschicht zwischen Substrat (6) und Halbleiterschicht (5) angeordnet sind, sowie teilweise als Metallisierung auf der Oberfläche der Halbleiterschicht (5) aufgetragen sind und je einen elektrischen Kontakt mit je einer Kontaktdiffusion (7 bis 15) haben, wobei die Kontaktdiffusionen (7 bis 15) an der Oberfläche in der Halbleiterschicht (5) gelegen sind, dass jede Anordnung (1 bis 4) seitlich von einem Isolationsring (16 ; 17, 17 ; 18) umgeben ist, dass das Substrat (6) sowie die Isolationsringe (16 ; 17, 17 ; 18) alle aus einem Halbleitermaterial eines gleichen Materialleitfähigkeitstyps (P) und die Halbleiterschicht (5), die vergrabenen Schichten und die Kontaktdiffusionen (7 bis 15) alle aus einem Halbleitermaterial vom andern Materialleitfähigkeitstyp (N) bestehen, wobei die vergrabenen Schichten und die Kontaktdiffusionen (7 bis 15) alle stark mit Fremdatomen dotiert sind.

3. Integrierbares Hallelement nach Anspruch 2, dadurch gekennzeichnet, dass, falls mit einem Stromanschluss (C₁ bzw. C₂) zu verbindende Punkte vergrabene Schichten (a1, b1, c1, d1, a3, b3, c3, d3) sind, diese vergrabene Schichten (a1, b1, c1, d1, a3, b3, c3, d3) je eine einzige gemeinsame vergrabene Schicht (a1 ; b1 ; c1 ; d1 bzw. a3 ; b3 ; c3 ; d3) pro Anordnung (2 bzw. 3) bilden, dass die einzige gemeinsame vergrabene Schicht (a1 ; b1 ; c1 ; d1 ; bzw. a3 ; b3 ; c3 ; d3) jeweils durch je eine tiefe Diffusion (20 bzw. 21), die voll durch die Halbleiter-schicht (5) hindurchgeht, mit der Oberfläche des Hallelementes verbunden ist und dass die tiefe Diffusion (20 bzw. 21)jeweils dort mit einem Stromanschluss (C₁ bzw. C₂) des Hallelementes verbunden ist, wobei die tiefen Diffusionen (20, 21) aus Material beste hen, das vom gleichen Materialleitfähigkeitstyp (N⁺) ist wie die vergrabenen Schichten und das wie diese stark mit Fremdatomen dotiert ist.

4. Integrierbares Hallelement nach Anspruch 1, dadurch gekennzeichnet, dass zwei Anordnungen (2, 3) vorhanden sind, die gegeneinander um einen Winkel von annähernd 90° um eine senkrecht zur Oberfläche verlaufende Achse verdreht in der Halbleiterschicht (5) angeordnet sind, dass die Halbleiterschicht (5) eine auf ainem Substrat (6) aufgewachsene Epitaxie-Schicht ist, dass die Verbindungen zwischen Aequipotentialpunkten und Verbindungen zu den Stromanschlüssen (C₁, C₂) als Metallisierung auf der Oberfläche der Halbleiter-schicht (5) aufgetragen sind und je einen elektrischen Kontakt mit je einer Kontaktdiffusion (7 bis 12 und 25 bis 32) besitzen, wobei die Kontaktdiffusionen (7 bis 12 und 25 bis 32) an der Oberfläche in der Halbleiter-schicht (5) gelegen sind, dass jede Anordnung (2, 3) seitlich von einem Isolationsring (23, 24) umgeben ist, dass das Substrat (6) sowie die Isolationsringe (23, 24) alle aus einem Halbleitermaterial eines gleichen Materialleitfähigkeitstyps (P) und die Halbleiter-schicht (5) sowie die Kontaktdiffusionen (7 bis 12 und 25 bis 32) alle aus einem Halbleiterraterial vom anderen Materialleitfähigkeitstyp (N) bestehen, wobei die Kontaktdiffusionen (7 bis 12 und 25 bis 32) alle stark mit Fremdatomen dotiert sind, und dass jede Anordnung (2 bzw. 3) zwei Kontaktdiffusionsreihen (25 ; 26 ; 27 ; 28 und 7 ; 8 ; 9 bzw. 10 ; 11 ; 12 und 29 ; 30 ; 31 ; 32) besitzt, wobei jeweils eine Kontaktdiffusion der einen Reihe einer Kontaktdiffusion der andern Reihe an der Oberfläche in der Halbleiter- schicht (5) gegenüber liegt, und dass die Kontaktdiffusionen der beiden äusseren Reihen (25, 26, 27, 28 bzw. 29, 30, 31, 32) alle mit je einem Stromanschluss (C₁ bzw. C₂) des Hallelementes verbunden sind.

5. Integrierbares Hallelement nach einem der Ansprüche 1 bis 5, darduch gekennzeichnet, dass die Halbleiterschicht (5) mit einer Oberflächenschicht (22) bedeckt ist, die aus einem Material (P) besteht, das vom andern Materialleitfähigkeitstyp ist als die Halbleiterschicht (5).

6. Verwendung des integrierbaren Hallelementes nach einem der Ansprüche 1 bis 5 in einem Elektrizitätszähler zur Messung eines von einem elektrischen Strom erzeugten Magnetfeldes ($\vec{H}$).

## Claims

1. An integratable Hall element comprising a first current terminal (C₁), a second current terminal (C₂) and two sensor terminals (S₁, S₂) which in operation is provided with an electrical Hall field and a current density, characterised in that a Hall element whose two current terminals ($C_1$, $C_2$) and whose two sensor terminals ($S_1$, $S_2$) are arranged at respective pairs of the oppositely disposed sides thereof is divided into a plurality of arrangements (1, 2, 3, 4 and 2, 3 respectively) by at least one section plane transversely with respect to the vectorial direction of the current density, that the centres of terminal contacts of the sensor terminals ($S_1$, $S_2$) lie in a section plane, that there are at least two connections per section plane, whereby two equipotential points of two respective adjacent arragements, which equipotential points are disposed on respective sides of the section plane are electrically conductively connected, that in relation to a section plane the equipotential points are points which are at the same electrical potential as the two sensor terminals($S_1$, $S_2$) to which they are then connected, that the arrangements (1, 2, 3, 4 and 2, 3 respectively) are arranged in displaced relationship in such a way that a surface lies transversely to the vectorial direction of the current density in all arrangements (1, 2, 3, 4 and 2, 3 respectively) in a respective single common plane and in operation the relative position of the vectorial directions of the current density, the electrical Hall field and a magnetic field ($\vec{H}$) to be measured is respectively retained, and that the arrangements (1, 2, 3, 4 and 2, 3 respectively) are disposed in a semiconductor layer (5) and the common plane is the surface plane of the semiconductor layer (5).

2. An integratable Hall element according to claim 1 characterized in that the semiconductor layer (5) is an epitaxial layer which is grown on a substrate (6), that the connections between equipotential points and connections to the current terminals ($C_1$, $C_2$) partially comprise buried layers which are disposed in the interface between the substrate (6) and the semiconductor layer (5) and are partially applied as metallisation. means to the surface of the semiconductor layer (5) and each have an electrical contact with a respective contact diffusion (7 to 15), wherein the contact diffusions (7 to 15) are disposed at the surface in the semiconductor layer (5), that each arrangement (1 to 4) is laterally surrounded by an insulating ring (16 ; 17, 17 ; 18), that the substrate (6) and the insulating rings (16 ; 17, 17 ; 18) all comprise a semiconductor material of one same material conductivity type (P) and the semiconductor layer (5), the buried layers and the contact diffusions (7 to 15) all comprise a semiconductor material of the other material conductivity type (N), wherein the buried layers and the contact diffusions (7 to 15) are all heavily doped with impurity atoms.

3. An integratable Hall element according to claim 1 characterised in that, if points to be connected to a current terminal ($C_1$ or $C_2$) are buried layers (a1, b1, c1, d1, a3, b3, c3, d3), said buried layers (a1, b1, c1, d1, a3, b3, c3, d3) each form a single common buried layer (a1 ; b1 ; c1 ; d1 and a3 ; b3, c3 ; d3) per arrangement (2 and 3 respectively), that the single common buried layer (a1 ; b1 ; c1 ; d1 and a3 ; b3 ; c3 ; d3) is respectively connected by a respective deep diffusion (20 and 21 respectively) which passes fully through the semiconductor layer (5) to the surface of the Hall element, and that the deep diffusion (20 and 21 respectively) is there respectively connected to a current terminal ($C_1$ and $C_2$ respectively) of the Hall element, wherein in the deep diffusions (20, 21) comprise material which is of the same material conductivity type ($N^+$) as the buried layers and which like them is heavily doped with impurity atoms.

4. An integratable Hall element according to claim 1 characterised in that there are two arrangements (2, 3) which are arranged in the semiconductor layer (5) in a condition of being turned relative to each other through an angle of approximately 90° about an axis extending perpendicularly to the surface, that the semiconductor layer (5) is an epitaxial layer which is grown on a substrate (6), that the connections between equipotential points and connections to the current terminals (C1, C2) are applied in the form of metallisation means to the surface of the semiconductor layer (5) and each have a respectively electrical contact with a respective contact diffusion (7 to 12 and 25 to 32), wherein the contact diffusions (7 to 12 and 25 to 32) are disposed at the surface in the semiconductor layer (5), that each arrangement (2, 3) is laterally surrounded by an insulating ring (23, 24), that the substrate (6) and the insulating rings (23, 24) all comprise a semiconductor material of a same material conductivity type (P) and the semiconductor layer (5) and the contact diffusions (7 to 12 and 25 to 32) all comprise a semiconductor material of the other material conductivity type (N), wherein in the contact diffusions (7 to 12 and 25 to 32) are all heavily doped with impurity atoms, and that each arrangement (2 and 3) has two contact diffusion rows (25 ; 26 ; 27 ; 28 and 7 ; 8 ; 9, and 10 ; 11 ; 12 and 29 ; 30 ; 31 ; 32 respectively), wherein a respective contact diffusion in one row is opposite a contact diffusion in the other row at the surface in the semiconductor layer (5), and that the contact diffusions of the two outer rows (25, 26, 27, 28 and 29, 30, 31, 32 respectively) are all connected to a respective current terminal ($C_1$ and $C_2$ respectively) of the Hall element.

5. An integratable Hall element according to one of claims 1 to 4 characterized in that the semiconductor layer (5) is covered with a surface layer (22) which comprises a material (P) which is of the other material conductivity type from the semiconductor layer (5).

6. Use of the integratable Hall element according to one of claim 1 to 5 in an electricity meter for measuring a magnetic field ($\vec{H}$) produced by an electrical current.

## Revendications

1. Elément Hall intégrable comportant une première connexion de courant (C₁), une seconde connexion de courant (C2) et deux connexions de détecteur (S₁, S₂), qui est pourvu en service d'un champ Hall électrique et d'une densité de courant, caractérisé en ce qu'un élément Hall, dont les deux connexions de courant (C₁, C₂) et dont les deux connexions de détecteur (S₁, S₂) sont respectivement disposées sur deux de ses côtés mutuellement opposés, est divisé par au moins une surface de coupe, orientée perpendiculairement à la direction vectorielle de la densité de courant, en plusieurs ensembles (1, 2, 3, 4 ou 2, 3), en ce que les centres des contacts de jonction des connexions de détecteur (S₁, S₂) sont situés dans une surface de coupe, en ce qu'il est prévu respectivement au moins deux liaisons par surface de coupe, de sorte que respectivement deux points de potentiels égaux, situés de chaque côté de la surface de coupe, sont reliés de façon électriquement conductrice avec deux ensembles adjacents, en ce que, dans une surface de coupe, les points de potentiels égaux sont des points qui ont le même potentiel électrique que les deux connexions de détecteur (S₁, S₂) avec lesquelles ils sont alors reliés et en ce que les ensembles (1, 2, 3, 4 ou 2, 3) sont disposés de façon décalée de telle sorte qu'une surface, perpendiculaire à la direction vectorielle de la quantité de courant, de tous les ensembles (1, 2, 3, 4 ou 2, 3) soit respectivement située dans un seul plan commun et, en service, la disposition relative des orientations vectorielles de la densité de courant, du champ Hall électrique et d'un champ magnétique ($\vec{H}$) à mesurer est respectivement conservée, et en ce que les ensembles (1, 2, 3, 4 ou 2, 3) sont disposés dans une couche semiconductrice (5) et le plan commun est le plan de surface de la couche semiconductrice (5).

2. Elément Hall intégrable selon la revendication 1, caractérisé en ce que la couche semiconductrice (5) est une couche épitaxiale formée par grossissement sur un substrat (6), en ce que les liaisons entre des points de potentiels égaux et les liaisons avec les connexions de courant (C₁, C₂) se composent partiellement de couches enfouies, qui sont disposées dans la couche-limite entre le substrat (6) et la couche semiconductrice (5), en étant également déposées partiellement sous forme d'une métallisation sur la surface de la couche semiconductrice (5) et en comportant chacune un contact électrique pourvu d'une diffusion de contact (7 à 15), les diffusions de contact (7 à 15) étant situées sur la surface de la couche semiconductrice (5), en ce que chaque ensemble (1 à 4) est entouré latéralement par un anneau d'isolation (16 ; 17, 17 ; 18), en ce que le substrat (6) ainsi que les anneaux d'isolation (16 ; 17, 17 ; 18) se composent tous d'un matériau semiconducteur du même type de conductivité (P), et la couche semiconductrice (5), les couches enfouies et les diffusions de contact (7 à 15) se composent toutes d'un matériau semiconducteur d'un autre type de conductivité (N), les couches enfouies et les diffusions de contact (7 à 15) étant toutes dopées fortement avec des atomes étrangers.

3. Elément Hall intégrable selon la revendication 2, caractérisé en ce que, dans le cas où des points à relier à une connexion de courant (C₁ ou C₂) sont des couches enfouies (a1, b1, c1, d1, a3, b3, c3, d3), ces couches enfouies (a1, b1, c1, d1, a3, b3, c3, d3) forment chacune une seule couche enfouie commune (a1 ; b1 ; c1 ; d1 ou a3 ; b3 ; c3 ; d3) par ensemble (2 ou 3), en ce que l'unique couche enfouie commune (a1 ; b1 ; c1 ; d1 ou a3 ; b3 ; c3 ; d3) est reliée par une diffusion profonde respective (20 ou 21), qui traverse complètement la couche semiconductrice (5), avec la surface de l'élément Hall et en ce que la diffusion profonde (20 ou 21) est respectivement reliée à une connexion de courant (C₁ ou C₂) de l'élément Hall, les diffusions profondes (20, 21) étant formées d'un maté riau qui est du même type de conductivité (N⁺) que les couches enfouies et qui est dopé avec les atomes étrangers aussi fortement qu'elles.

4. Elément Hall intégrable selon la revendication 1, caractérisé en ce qu'il est prévu deux ensembles (2, 3), qui sont disposés dans la couche semiconductrice (5) en étant tournés l'un par rapport à l'autre d'un angle d'environ 90° autour d'un axe orienté perpendiculairement à la surface, en ce que la couche semiconductrice (5) est une couche épitaxiale formée par grossissement sur un substrat (6), en ce que les liaisons entre des points de potentiels égaux et des liaisons avec les connexions de courant (C₁, C₂) sont déposées sous forme d'une métallisation sur la surface de la couche semiconductrice (5) et comportent chacune un contact électrique avec une diffusion de contact respective (7 à 12 et 25 à 32), les diffusions de contact (7 à 12 et 25 à 32) étant situées sur la surface de la couche semiconductrice (5), en ce que chaque ensemble (2, 3) est entouré latéralement par un anneau d'isolation (23, 24), en ce que le substrat (6) ainsi que les anneaux d'isolation (23, 24) sont tous constitués d'un matériau semiconducteur ayant un même type de conductivité (P) et la couche semiconductrice (5) ainsi que les diffusions de contact (7 à 12 et 25 à 32) sont toutes constituées d'un matériau semiconducteur ayant un autre type de conductivité (N), les diffusions de contact (7 à 12 et 25 à 32) étant toutes dopées fortement avec des atomes étrangers et en ce que chaque ensemble (2 ou 3) comporte deux rangées de diffusion de contact (25 ; 26 ; 27 ; 28 et 7 ; 8 ; 9 ou 10 ; 11 ; 12 et 29 ; 30 ; 31 ; 32), respectivement une diffusionde contact d'une des rangées étant placée en regard d'une diffusion de contact de l'autre rangée sur la surface de la couche semiconductrice (5), et en ce que les diffusions de contact des deux rangées extérieures (25, 26, 27, 28 ou 29, 30, 31, 32) sont toutes reliées avec une connexion de courant respective ($C_1$ ou $C_2$) de l'élément Hall.

5. Elément Hall intégrable selon une des revendications 1 à 4, caractérisé en ce que la couche semiconductrice (5) est recouverte d'une couche superficielle (22) qui se compose d'un matériau (P) qui est d'un autre type de conductivité que la couche semiconductrice (5).

6. Utilisation de l'élément Hall intégrable selon une des revendications 1 à 5 dans un compteur d'électricité pour une mesure d'un champ magnétique ($\vec{H}$) produit par un courant électrique.

# Fig.1

## Fig.2a

## Fig.2 b

**Fig. 3**

**Fig. 4**

# Fig.5

Fig. 6

# Fig.7

# Fig.8

# Fig. 9 a

# Fig. 9 b